(19) Europäisches Patentamt
European Patent Office
Office européen des brevets

(11) **EP 0 805 550 A1**

(12) **EUROPÄISCHE PATENTANMELDUNG**

(43) Veröffentlichungstag:
05.11.1997 Patentblatt 1997/45

(51) Int. Cl.$^6$: **H03F 1/48**

(21) Anmeldenummer: 96119741.5

(22) Anmeldetag: 10.12.1996

(84) Benannte Vertragsstaaten:
DE FR GB IT

(30) Priorität: 03.05.1996 DE 19617692

(71) Anmelder: **ROBERT BOSCH GMBH**
**70442 Stuttgart (DE)**

(72) Erfinder:
**Schmid, Eberhard, Dr. Dipl.-Ing.**
**72770 Reutlingen (DE)**

(54) **Gleichstromgekoppelter Breitbandverstärker mit geringem Offset**

(57) Es wird eine Breitbandverstärkerschaltung mit zwei Schaltungsteilen vorgeschlagen, die beide mit dem gleichen an einem Signaleingang angelegten Eingangssignal beaufschlagt werden, wobei ein erster Schaltungsteil einen Operationsverstärker enthält und für die Verstärkung niedriger Frequenzen dient und ein zweiter Schaltungsteil einen breitbandigen Hochfrequenzverstärker aufweist, dadurch gekennzeichnet, daß über einen Summierpunkt vor einem Schaltungsausgang eine Signaleinspeisung aus dem zweiten Schaltungsteil erfolgt und daß der erste Schaltungsteil mit einer ohmschen Gegenkopplung versehen ist, wobei die Abnahme eines Rückführungssignals für die Gegenkopplung an einem Ausgangsverbindungsknoten hinter dem Summierpunkt erfolgt.

Fig.2

EP 0 805 550 A1

# Beschreibung

## Stand der Technik

Die Erfindung geht aus von einem Breitbandverstärker nach der Gattung des Hauptanspruchs. In dem Buch „Halbleiterschaltungstechnik" von Tietze und Schenk, Springer-Verlag, 10. Auflage 1993, S. 508 - 510, ist bereits ein Breitbandverstärker beschrieben, der aus zwei Schaltungsteilen besteht, wobei ein erster Schaltungsteil zur Verstärkung von Signalen mit kleinen Frequenzen und ein zweiter Schaltungsteil zur Verstärkung von Signalen mit hohen Frequenzen dient. Bei dem beschriebenen Breitbandverstärker sind frequenzselektive Elemente erforderlich, ferner ist die Gesamtverstärkung des Breitbandverstärkers eine abnehmende Funktion der Signalfrequenz.

## Vorteile der Erfindung

Der erfindungsgemäße Breitbandverstärker mit den kennzeichnenden Merkmalen des Hauptanspruchs hat demgegenüber den Vorteil, in einfacher Weise eine Kombination von zwei Schaltungsteilen zu realisieren, die jeweils auf Niederfrequenz- beziehungsweise Hochfrequenzeigenschaften optimiert werden. Im Vergleich zum Stand der Technik gelingt es, ohne frequenzselektives Element bei minimalem zusätzlichem Aufwand gegenüber einer einfachen Operationsverstärkerschaltung die Verstärkungsbandbreite zu erhöhen und im wesentlichen den Offset einer einfachen Operationsverstärkerschaltung zu erhalten, bei weitgehender Unabhängigkeit von den Grenzfrequenzen der beiden Schaltungsteile. Bei Anwendung in diskreten Schaltungen können kostengünstigst durch Verwendung von billigen diskreten Operationsverstärkern und einigen billigen Hochfrequenztransistoren Breitbandverstärker (Gleichspannung bis Hochfrequenz von 10 bis 100 Megahertz) zum Beispiel für Meßzwecke realisiert werden, wobei im wesentlichen die Offseteigenschaften des diskreten Operationsverstärkers beibehalten bleiben. Ein in einem Schaltungsverbund enthaltener erster Schaltungsteil mit einem Operationsverstärker bestimmt die Eigenschaften des Verstärkers bei Niederfrequenz und den Offset, ein als Hochfrequenzverstärker dimensionierter zweiter Schaltungsteil bestimmt die Hochfrequenzeigenschaften und das Großsignalverhalten bei schnellen Signalwechseln.

Als weiterer Vorteil ist anzusehen, daß durch einen geeignet ausgestalteten Regelkreis parasitäre Offsetsignale ausgeregelt werden, die gegebenenfalls aus dem Schaltungsteil eingespeist werden, der Signale mit hohen Frequenzen verstärkt.

Durch die in den abhängigen Ansprüchen aufgeführten Maßnahmen sind vorteilhafte Weiterbildungen und Verbesserungen des im Hauptanspruch angegebenen Breitbandverstärkers möglich. Besonders vorteilhaft ist, daß durch eine geeignete Wahl der Verstärkung des ersten und zweiten Schaltungsteils beziehungsweise des Faktors einer vorgesehenen Gegenkopplung eine Verstärkung der Gesamtschaltung mit geringem Offset erhalten wird, die über einen großen Frequenzbereich einen konstanten Wert annimmt. Der erfindungsgemäße Breitbandverstärker benötigt keine umfassende Gegenkopplung, wie sie bei dem im Stand der Technik beschriebenen Breitbandverstärker zusätzlich anzubringen wäre, um eine über der Frequenz bis zu einer Nutzbandbreite konstante Verstärkung zu erhalten. Die beiden Schaltungsteile sind weitgehend unabhängig von der Forderung konstanter Verstärkung bis zu einer möglichst großen Nutzbandbreite auf Nieder- bzw. Hochfrequenzeigenschaften optimierbar.

In vorteilhafter Weise können für den ersten und zweiten Schaltungsteil jeweils MOS-Transistoren oder Bipolartransistoren verwendet werden, beispielsweise für den zweiten Schaltungsteil, der zur Verstärkung hoher Frequenzen dient, Transistoren in Bipolartechnik, um ein gutes Signalfolgeverhalten bei schnellen Änderungen der Signalamplitude zu gewährleisten.

In einer einfachen Realisierung kann der erste Schaltungsteil als Operationsverstärker ausgeführt sein, der mit einem Differenzverstärker kombiniert ist. Der zweite Schaltungsteil ist als Differenzverstärker mit schnellen Transistoren ebenfalls in einfacher Weise realisierbar.

## Zeichnung

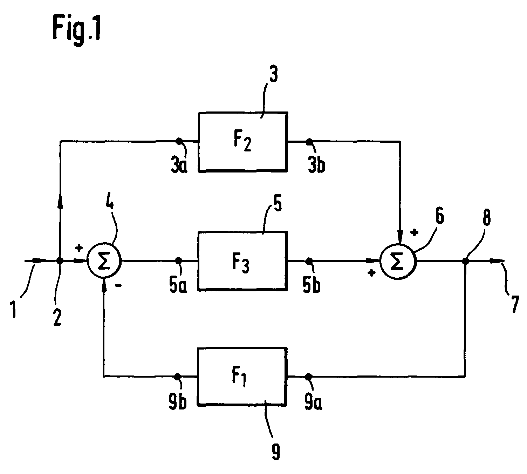

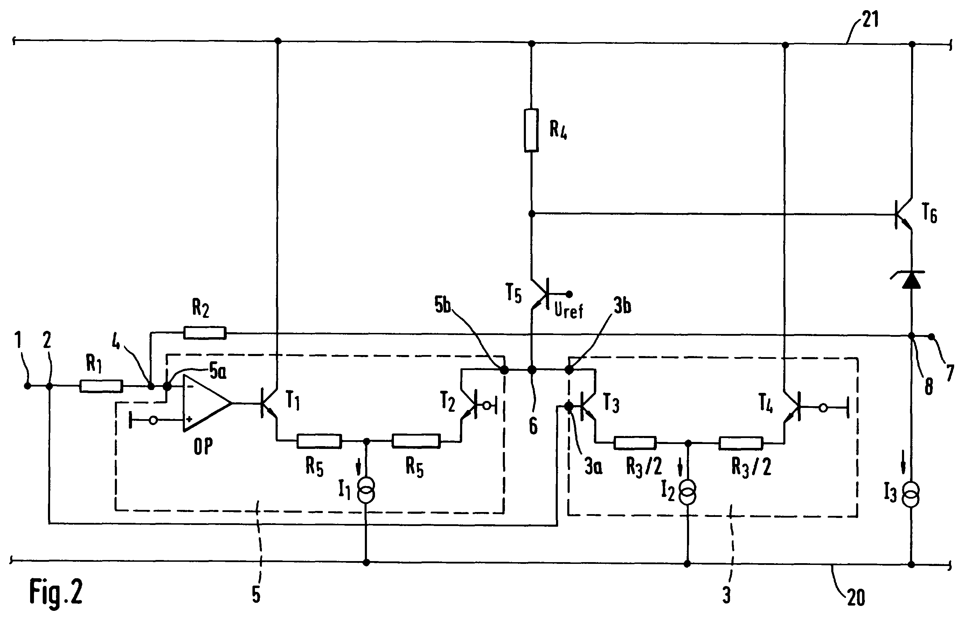

Ein Ausführungsbeispiel der Erfindung ist in der Zeichnung dargestellt und in der nachfolgenden Beschreibung näher erläutert. Es zeigen Figur 1 ein Blockschaltbild, Figur 2 eine einfache Realisierung des erfindungsgemäßen Breitbandverstärkers.

## Beschreibung des Ausführungsbeispiels

Figur 1 zeigt das Blockschaltbild eines Breitbandverstärkers mit einem ersten Schaltungsteil 5, einem zweiten Schaltungsteil 3 und einer Gegenkopplung 9. Der erste Schaltungsteil 5 ist ein Verstärker mit der Verstärkung $F_3$, der zweite Schaltungsteil 3 ist ein Verstärker mit der Verstärkung $F_2$, die Gegenkopplung 9 hat die Verstärkung $F_1$. Ein Signaleingang 1 ist über einen Eingangsverbindungsknoten 2 sowohl über einen Eingangssummationspunkt 4 mit einem Eingang 5a des ersten Schaltungsteils 5 als auch direkt mit einem Eingang 3a des zweiten Schaltungsteils 3 verbunden. Ausgänge des ersten und zweiten Schaltungsteils (5b beziehungsweise 3b) sind über einen Summierpunkt 6 miteinander verbunden. Der Summierpunkt 6 ist mit einem Signalausgang 7 verbunden, wobei über einen Ausgangsverbindungsknoten 8 ein am Signalausgang 7 anliegendes Ausgangssignal mit einem Eingang 9a der Gegenkopplung 9 verbunden ist. Ein Ausgang 9b der Gegenkopplung 9 wird dem Eingangssummationspunkt 4 zugeführt, so daß am ersten Schaltungsteil 5 das Eingangssignal abzüglich des $F_1$-fach verstärkten Ausgangssignales anliegt.

Der erste Schaltungsteil 5 ist als Niederfrequenzverstärker und der zweite Schaltungsteil 3 als Hochfrequenzverstärker ausgeführt. Das Zusammenspiel der Schaltungsteile kann man sich qualitativ folgendermaßen vorstellen: Liegen Signale mit sehr niedrigen Frequenzen am Signaleingang an, so spricht der zweite Schaltungsteil 3, sofern er Hochpaßeigenschaften hat und für die Verstärkung von Signalen mit hohen Frequenzen vorgesehen ist, nicht oder nur schwach darauf an, an seinem Signalausgang 3b liegt nur ein entsprechend kleines Signal an. Bei niedrigen Frequenzen verstärkt nur der erste Schaltungsteil gemäß der Verstärkung des ersten Schaltungsteils unter Berücksichtigung der Gegenkopplung. Erhöht man allmählich die Frequenz des Signales am Signaleingang, so trägt am Summierpunkt 6 zunehmend der zweite Schaltungsteil zum Ausgangssignal bei. Da aber der Ausgangsverbindungsknoten 8 hinter dem Summierpunkt 6 liegt, ist das am Eingang des ersten Schaltungsteils berücksichtigte Gegenkopplungssignal umso größer, je mehr der als Hochfrequenzverstärker dienende zweite Schaltungsteil zum Ausgangssignal beiträgt. Dadurch ist ein gleitender Übergang der Übernahme der Verstärkungsfunktion des Breitbandverstärkers vom ersten Schaltungsteil hin zum zweiten Schaltungsteil realisierbar.

Auf die oben geschilderte Art und Weise erzielt man eine breitbandige Verstärkung, wobei der erste Schaltungsteil mit der Verstärkung $F_3$ bezüglich hoher Verstärkung bei tiefen Frequenzen und bezüglich geringem Offset optimierbar ist, während der zweite Schaltungsteil mit der Verstärkung $F_2$ bezüglich Breitbandigkeit und dem Signalfolgeverhalten bei schnellen Amplitudenänderungen (slew rate) optimierbar ist.

Quantitativ gilt für die Verstärkung F des Breitbandverstärkers gemäß Figur 1 der folgende Zusammenhang:

$$F(f) = \frac{F_2(f) + F_3(f)}{1 + F_1(f) \cdot F_3(f)},$$

mit

F    = Gesamtverstärkung des Breitbandverstärkers,
f    = Frequenz des Eingangssignals,
$F_1$   = Verstärkung der Gegenkopplung,
$F_2$   = Verstärkung des zweiten Schaltungsteils,
$F_3$   = Verstärkung des ersten Schaltungsteils.

Eine vorteilhafte Wahl der Verstärkungen $F_1$, $F_2$ und $F_3$ besteht darin, eine Gesamtverstärkung F zu erreichen, die über den gesamten zur Verfügung stehenden Frequenzbereich, dessen obere Grenze lediglich durch die Hochfrequenzeigenschaften des zweiten Schaltungsteils bestimmt wird, einen konstanten Wert annimmt. Dies erreicht man, indem zum einen sich die Frequenzbereiche überlappen, in denen die beiden Schaltungsteile jeweils eine konstante Verstärkung liefern. Es wird also eine untere Grenzfrequenz des als Hochfrequenzverstärker ausgebildeten zweiten Schaltungsteils, die die untere Grenze konstanter Verstärkung des zweiten Schaltungsteils definiert, kleiner gewählt als eine obere Grenzfrequenz des als Niederfrequenzverstärker ausgebildeten ersten Schaltungsteils, die die obere Grenze konstanter Verstärkung des ersten Schaltungsteils definiert. Dabei kann die untere Grenzfrequenz des zweiten Schaltungsteils sehr klein gewählt werden, auch der Grenzfall Null ist möglich. Zum anderen ist für die Verstärkungen $F_1$, $F_2$ und $F_3$ folgende Wahl zu treffen:

1. Für Signalfrequenzen unterhalb der oberen Grenzfrequenz des ersten Schaltungsteils soll die Verstärkung $F_3$ betragsmäßig groß gegen 1 und betragsmäßig groß gegen die Verstärkung $F_2$ des zweiten Schaltungsteils sein.
2. Außerdem soll für Frequenzen oberhalb der unteren Grenzfrequenz des zweiten Schaltungsteils die Verstärkung $F_2$ des zweiten Schaltungsteils eine reelle Größe und gleich dem Kehrwert der Verstärkung $F_1$ einer als ohmschen Gegenkopplung ausgebildeten Gegenkopplung 9 sein.

Dann nimmt die Gesamtverstärkung F der Schaltung gemäß Figur 1 den konstanten Wert $1/F_1$ an, bis zu einer oberen Grenze für die Frequenz des Eingangssignals, die durch die Hochfrequenzeigenschaften des zweiten Schaltungsteils bestimmt wird.

Figur 2 zeigt eine einfache Realisierung eines erfindungsgemäßen Breitbandverstärkers. Der Signaleingang 1 ist über einen Eingangswiderstand $R_1$ mit dem Eingang 5a des ersten Schaltungsteils 5 verbunden, der durch den invertierenden Eingang eines Operationsverstärkers realisiert ist. Der andere Eingang des Operationsverstärkers liegt auf Masse. Der Ausgang des Operationsverstärkers ist mit der Basis eines ersten Transistors $T_1$ verbunden. Der Kollektor des ersten Transistors ist mit dem Pluspol 21 einer Spannungsversorgung verbunden. Der Emitter ist über einen Widerstand $R_5$ und über eine erste Stromquelle $I_1$ mit dem Minuspol 20 der Spannungsversorgung verbunden. Der Emitter eines zweiten Transistors $T_2$ ist über einen gleich großen Widerstand $R_5$ über die erste Stromquelle $I_1$ ebenfalls mit dem Minuspol der Spannungsversorgung verbunden. Die Basis des zweiten Transistors liegt auf Masse. Der Kollektoranschluß des zweiten Transistors ist über den Ausgang 5b des ersten Schaltungsteils mit dem Summierpunkt 6 verbunden. Der zweite Schaltungsteil ist als Differenzverstärker aus einem dritten Transistor $T_3$, einem vierten Transistor $T_4$, zwei gleich großen Widerständen $R_3/2$ und einer zweiten Stromquelle $I_2$ aufgebaut. Die Basis des dritten Transistors ist über den Eingangsverbindungsknoten 2 mit dem Signaleingang 1 verbunden und stellt den Eingang 3a des zweiten Schaltungsteils dar. Der Kollektor des dritten Transistors ist mit dem Summierpunkt 6 verbunden und stellt den Ausgang 3b des zweiten Schaltungsteils dar. Die Emitter der Transistoren $T_3$ und $T_4$ sind über die gleich großen Widerstände $R_3/2$ über die gemeinsame zweite Stromquelle $I_2$ mit dem Minuspol der Spannungsversorgung verbunden. Die Basis des vierten Transistors $T_4$ liegt auf Masse. Der Kollektor des vierten Transistors ist mit dem Pluspol 21 der Spannungsversorgung verbunden.

Der Summierpunkt 6 ist am Emitter eines Summiertransistors $T_5$ angeschlossen, dessen Basis auf einem Referenzpotential liegt. Der Kollektor des Summiertransistors liegt zum einen über einem Summierwiderstand $R_4$ am Pluspol der Spannungsversorgung, zum anderen ist er an die Basis eines Ausgangstransistors $T_6$ angeschlossen. Der Kollektor des Ausgangstransistors liegt am Pluspol der Spannungsversorgung, der Emitter ist mit einer in Sperrichtung geschalteten Zenerdiode verbunden, die über eine dritte Stromquelle $I_3$ am Minuspol der Spannungsversorgung liegt. Zwischen der Zenerdiode und der dritten Stromquelle ist über den Ausgangsverbindungsknoten 8 der Signalausgang 7 angeschlossen. Ebenfalls mit dem Ausgangsverbindungsknoten 8 ist ein Gegenkopplungswiderstand $R_2$ verbunden, der wiederum über den Eingangssummationspunkt 4 mit dem Eingang 5a des ersten Schaltungsteils verbunden ist.

Der Operationsverstärker OP zusammen mit dem Differenzverstärker, der aus den Transistoren $T_1$ und $T_2$ gebildet wird, stellen den ersten Schaltungsteil dar, der zur Verstärkung niedriger Frequenzen dient. Die Widerstände $R_1$ und $R_2$ ergeben die Gegenkopplung 9. Bei einem geeignet gewählten Referenzpotential an der Basis des Summiertransistors $T_5$ ergibt sich am Summierpunkt 6 eine Addition der Kollektorströme der Transistoren $T_2$ und $T_3$ zum Emitterstrom des Transistors $T_5$. Dabei ist der Transistor $T_3$ Teil des hochfrequenzverstärkenden zweiten Schaltungsteils 3. Die breitbandige Hochfrequenzverstärkung mit der Verstärkung $F_2$ (siehe Figur 1) entsteht hier also in einstufiger Verstärkung durch den Differenzverstärker aus den Transistoren $T_3$ und $T_4$ über den Summiertransistor $T_5$, mit dem Verstärkungsfaktor entsprechend dem Verhältnis der Widerstände $R_4 : (2 \times R_3/2)$, das heißt $R_4 : R_3$. Dabei ist vorausgesetzt, daß die Transistoren $T_3$, $T_4$, $T_5$ unter den üblichen Betriebsbedingungen eingesetzt werden, so daß deren Eigenschaften in Grenzsituationen, wie beispielsweise bei kleinen Kollektor-Emitter-Spannungen, nicht zum Tragen kommen. Die Anordnung der Transistoren $T_5$ und $T_3$ hat die positiven Eigenschaften einer Kaskodeschaltung, das heißt, der Summierpunkt 6 ist weitgehend frei von Signalspannungen. Folglich ist die wirksame Eingangskapazität an der Basis des Transistors $T_3$ niedrig, man vermeidet die Miller-Kapazität. Die Summation der Kollektorströme $T_2$ und $T_3$ erfolgt ohne gegenseitige Wechselwirkung. Die Transistorpaare $T_1$, $T_2$ und $T_3$, $T_4$ werden über die Gleichstromquellen $I_1$ beziehungsweise $I_2$ im geeigneten Stromarbeitspunkt betrieben. Die an $R_4$ entstehende Signalspannung wird über den Transistor $T_6$ in Kollektorschaltung als Impedanzwandler und einer als Pegelschieber geschalteten Zenerdiode auf den Ausgang übertragen. Der Pegelhub, hier mittels passender Zenerdiode, kann auch mit den sonst einschlägigen Pegelschieberschaltungen realisiert werden. Dazu bestehen keinerlei Genauigkeitsanforderungen. Der Pegel sollte lediglich grob in den erforderlichen Bereich geschoben werden, um eingebauten, systematischen Offset zu vermeiden. Die Gleichstromquelle $I_3$ betreibt $T_6$ im geeigneten Stromarbeitspunkt.

Bei Ausgestaltung der Schaltung nach Figur 2 mit diskreten Bauelementen und einem bekannten Operationsverstärker ist ebenfalls wie bei vollständiger Dimensionierung als eine integrierte Schaltung auf die Stabilität einer durch 4, 5, 6, 8 und 9 gegebenen Regelschleife zu achten. In dem Rückkopplungskreis des Operationsverstärkers darf nur begrenzte zusätzliche Verstärkung eingebracht werden, da sonst die üblicherweise OP-interne Frequenzgangkompensation unwirksam wird. Zweckmäßigerweise wählt man die Widerstände $R_5$ ungefähr halb so groß wie $R_4$, so daß die Transistoren $T_1$, $T_2$ keine zusätzliche Ringverstärkung in der Regelschleife bewirken.

Das Widerstandsverhältnis $R_4 : R_3$ bestimmt die Verstärkung des zweiten Schaltungsteils. Wird zusätzlich die Verstärkung der ohmschen Gegenkopplung 9 so gewählt, daß sie dem Kehrwert der Verstärkung des zweiten Schaltungsteils entspricht, wenn also gilt:

$$R_4/R_3 = R_2/R_1,$$

dann ist die Verstärkung der gesamten Schaltung nach Figur 1 durch $R_4/R_3$ gegeben, und die oben beschriebenen Bedingungen für eine konstante breitbandige Verstärkung des erfindungsgemäßen Breitbandverstärkers sind erfüllt.

Die Schaltung in Figur 2 ist beispielhaft. Selbstverständlich können unter anderem die Transistoren in Form von Emitterfolgern modifiziert werden. Die Transistoren $T_3$, $T_4$, $T_5$ und $T_6$ sollten gute Hochfrequenzeigenschaften haben, wohingegen dies für $T_1$ und $T_2$ nicht erforderlich ist. In Figur 2 sind Bipolartransistoren dargestellt. Je nach Anforderungen sind auch MOS-Transistoren einsetzbar. Die Ausgestaltung des Operationsverstärkers für Realisierungen in integrierten Schaltungen, die beispielsweise in Mischtechniken (Bipolar- und MOS-Technik) ausgeführt sind, kann mit CMOS-Transistoren erfolgen, fallweise für gute Offset-Eigenschaften sollten jedoch die Eingangsstufen mit Bipolartransistoren ausgeführt werden. Der als Hochfrequenzverstärker dienende zweite Schaltungsteil ist allgemein als ein- oder mehrstufiger breitbandiger Hochfrequenzverstärker realisierbar, der bezüglich Hochfrequenzeigenschaften optimiert ist. Sein Niederfrequenzverhalten und sein Offset sind zweitrangig. Der erste Schaltungsteil ist bezüglich geringem Offset und hoher Verstärkung zu optimieren. Breitbandigkeit ist beim ersten Schaltungsteil zweitrangig. In einer praktischen Ausführung, bei der der erste Schaltungsteil als Operationsverstärker realisiert wird, ist dessen Großsignalverhalten bei schnellen Signalwechseln (slew rate) zweitrangig, da als Folge der Differenzbildung im Summationspunkt 4 für schnelle Signalwechsel der erste Schaltungsteil kein Ansteuerungssignal erhält. Die Großsignaleigenschaften bei hohen Frequenzen werden daher ausschließlich durch den zweiten Schaltungsteil, den Summationspunkt 6, die Gegenkopplung 9 und den Summierpunkt 4 bestimmt.

**Patentansprüche**

1. Breitbandverstärkerschaltung mit zwei Schaltungsteilen, die beide mit dem gleichen an einem Signaleingang (1) angelegten Eingangssignal beaufschlagt werden, wobei ein erster Schaltungsteil (5) einen Operationsverstärker (OP) enthält und für die Verstärkung niedriger Frequenzen dient und ein zweiter Schaltungsteil (3) einen breitbandigen Hochfrequenzverstärker aufweist, dadurch gekennzeichnet, daß über einen Summierpunkt (6) vor einem Schaltungsausgang (7) eine Signaleinspeisung aus dem zweiten Schaltungsteil (3) erfolgt und daß der erste Schaltungsteil (5) mit einer ohmschen Gegenkopplung (9) versehen ist, wobei die Abnahme eines Rückführungssignals für die Gegenkopplung (9) an einem Ausgangsverbindungsknoten (8) zwischen dem Summierpunkt (6) und dem Schaltungsausgang (7) erfolgt.

2. Breitbandverstärkerschaltung nach Anspruch 1, dadurch gekennzeichnet, daß der erste Schaltungsteil (5) eine obere Grenzfrequenz und der zweite Schaltungsteil (3) eine untere Grenzfrequenz aufweist, die kleiner ist als die obere Grenzfrequenz des ersten Schaltungsteils, daß für Eingangssignale mit Frequenzen kleiner als die obere Grenzfrequenz des ersten Schaltungsteils die Verstärkung des ersten Schaltungsteils groß im Vergleich zu 1 und groß im Vergleich zur Verstärkung des zweiten Schaltungsteils ist und daß für Eingangssignale mit Frequenzen größer als die untere Grenzfrequenz des zweiten Schaltungsteils die Verstärkung des zweiten Schaltungsteils gleich dem Kehrwert des Betrags der Verstärkung der Gegenkopplung ist.

3. Breitbandverstärkerschaltung nach Anspruch 1 oder 2, dadurch gekennzeichnet, daß der zweite Schaltungsteil (3) in Bipolartechnik ausgeführt ist.

4. Breitbandverstärkerschaltung nach einem der vorhergehenden Ansprüche, dadurch gekennzeichnet,

daß der erste Schaltungsteil (5) einen Differenzverstärker enthält, der aus einem ersten und einem zweiten Transistor ($T_1$ bzw. $T_2$) gebildet wird, deren Emitter über gleich große Widerstände ($R_5$) an eine erste Stromquelle

($I_1$), die mit einem Minuspol (20) einer Spannungsversorgung verbunden ist, angeschlossen sind,
wobei der invertierende Eingang des Operationsverstärkers (OP) über einen Eingangswiderstand ($R_1$) mit dem Signaleingang (1) verbunden ist, der zweite Eingang des Operationsverstärkers auf Masse liegt und der Ausgang des Operationsverstärkers an die Basis des ersten Transistors ($T_1$) angeschlossen ist,
wobei der Kollektor des ersten Transistors ($T_1$) mit einem Pluspol (21) der Spannungsversorgung verbunden ist, wobei die Basis des zweiten Transistors ($T_2$) auf Masse liegt und der Kollektor des zweiten Transistors mit dem Summierpunkt (6) verbunden ist,
wobei der Summierpunkt (6) mit dem Emitter eines Summiertransistors ($T_5$) verbunden ist, dessen Basis auf einem konstanten Referenzpotential ($U_{ref}$) liegt und dessen Kollektor über einen Summierwiderstand ($R_4$) mit dem Pluspol (21) der Spannungsversorgung verbunden ist,
wobei der Kollektor des Summiertransistors ($T_5$) mit der Basis eines Ausgangstransistors ($T_6$) verbunden ist, dessen Kollektor mit dem Pluspol (21) der Spannungsversorgung und dessen Emitter mit einer als Pegelschieber dienenden Zenerdiode verbunden ist, die ihrerseits über eine dritte Stromquelle ($I_3$) mit dem Minuspol (20) der Spannungsversorgung verbunden ist,
wobei an die Verbindung zwischen Zenerdiode und dritter Stromquelle ($I_3$) der Schaltungsausgang (7) angeschlossen ist und
der Schaltungsausgang über den Ausgangsverbindungsknoten (8) und einen Gegenkopplungswiderstand ($R_2$) mit dem invertierenden Eingang des Operationsverstärkers des ersten Schaltungsteils (5) verbunden ist.

5. Breitbandverstärkerschaltung nach einem der vorhergehenden Ansprüche, dadurch gekennzeichnet,

daß der zweite Schaltungsteil (3) einen Differenzverstärker enthält, der aus einem dritten und einem vierten Transistor ($T_3$ bzw. $T_4$) gebildet wird, deren Emitter über gleich große Widerstände ($R_3/2$) an eine zweite Stromquelle ($I_2$), die mit dem Minuspol der Spannungsversorgung verbunden ist, angeschlossen sind,
wobei die Basis des dritten Transistors ($T_3$) über einen Eingangsverbindungsknoten (2) mit dem Signaleingang (1) verbunden ist,
der Kollektor des dritten Transistors mit dem Summierpunkt (6) verbunden ist,
die Basis des vierten Transistors ($T_4$) auf

Masse liegt und der Kollektor des vierten Transistors mit dem Pluspol (21) der Spannungsversorgung verbunden ist.

# Fig.1

Fig.2

| Europäisches Patentamt | **EUROPÄISCHER RECHERCHENBERICHT** | Nummer der Anmeldung |
|---|---|---|
| | | EP 96 11 9741 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | DE 34 46 660 A (HAHN MEITNER KERNFORSCH) 26.Juni 1986 <br> * Seite 4, Zeile 10 - Seite 7, Zeile 6 * <br> * Seite 8, Zeile 13 - Seite 11, Zeile 18; Abbildungen 2,3 * <br> --- | 1-3 | H03F1/48 |
| X | DE 38 29 135 A (LICENTIA GMBH) 1.März 1990 <br> * Spalte 1, Zeile 1 - Zeile 54 * <br> * Spalte 2, Zeile 52 - Spalte 3, Zeile 56; Abbildungen 3,4 * <br> --- | 1,3,4 | |
| A | NUCLEAR INSTRUMENTS AND METHODS, <br> Bd. 86, Nr. 2, 15.September 1970, <br> AMSTERDAM NL, <br> Seiten 317-321, XP002036585 <br> BARRANDON G.: "ÉTAGE AMPLIFICATEURS À HAUTES PERFORMANCES" <br> * Abbildungen 4-6 * <br> ----- | 1,5 | |
| | | | **RECHERCHIERTE SACHGEBIETE (Int.Cl.6)** |
| | | | H03F |

Der vorliegende Recherchenbericht wurde für alle Patentansprüche erstellt

| Recherchenort | Abschlußdatum der Recherche | Prüfer |
|---|---|---|
| DEN HAAG | 31.Juli 1997 | Dhondt, I |